# EUROPEAN PATENT SPECIFICATION

(11) **EP 2 095 427 B1**
(45) Date of publication and mention of the grant of the patent: **21.07.2010**
(21) Application number: 07849110.7
(22) Date of filing: 13.11.2007
(51) Int. Cl.: H01L 29/739

(54) **SELF-ALIGNED IMPACT-IONIZATION FIELD EFFECT TRANSISTOR**
SELBSTAUSGERICHTETER STOSSIONISATIONS-FELDEFFEKTTRANSISTOR
TRANSISTOR À EFFET DE CHAMP À IONISATION PAR IMPACT AUTO-ALIGNÉ

(30) Priority: 16.11.2006 EP 06124250
(43) Date of publication of application: 02.09.2009
(73) Proprietor: NXP B.V., 5656 AG Eindhoven (NL)
(72) Inventor: CURATOLA, Gilberto, Redhill, Surrey RH1 5HA (GB); VAN DAL, Mark, Redhill, Surrey RH1 5HA (GB); SONSKY, Jan, Redhill, Surrey RH1 5HA (GB)
(74) Representative: Burton, Nick
(86) International application number: PCT/IB2007/054607
(87) International publication number: WO 2008/059443

(56) References cited:
- US-A- 5 753 555
- US-A1- 2005 112 870
- GOPALAKRISHNAN K ET AL: "Novel Very High IE Structures Based on the Directed BBHE Mechanism for Ultralow-Power Flash Memories" IEEE ELECTRON DEVICE LETTERS, IEEE SERVICE CENTER, NEW YORK, NY, US, vol. 26, no. 3, March 2005 (2005-03), pages 212-215, XP011127275 ISSN: 0741-3106
- GOPALAKRISHNAN K ET AL: "Impact Ionization MOS (I-MOS)-Part II: Experimental Results" January 2005 (2005-01), IEEE TRANSACTIONS ON ELECTRON DEVICES, IEEE SERVICE CENTER, PISACATAWAY, NJ, US, PAGE(S) 77-84 , XP011124198 ISSN: 0018-9383 * Figure 7 and associated text *

## Description

The present invention relates to the fabrication of field effect transistor devices in which an insulated gate electrode is used to control an electric field in a semiconductor intermediate region between two more highly doped source / drain regions.

A significant problem faced recently in the semiconductor industry is the control of short channel effects in nanoscale transistor devices. As a consequence of the reduced control exerted by gate electrodes over carriers in an inversion channel beneath the gate electrode, there may be a significant degradation of sub-threshold slope in the high longitudinal field resulting from the drain to source voltage V_{DS}, and a consequent increase in off-state current. High off-state current is undesirable since it reduces the ability to control the transistor using the gate electrode and increases total static power consumption.

In a conventional bulk MOSFET device, the off-state current is represented by a thermal diffusion current over a potential barrier and, therefore, the Fermi-Dirac distribution of carriers in any case limits the minimum sub-threshold slope to the well-known value of 60 mV / decade. This ultimately provides a limitation on switching speed of the transistor even if short channel effects are perfectly controlled.

Therefore, there has been considerable interest in alternative devices based on different transport mechanisms where the intrinsic 60 mV / decade limit can be overcome. These alternative devices include tunnel devices and impact ionization devices which have a high degree of compatibility with conventional CMOS fabrication processes.

Further devices are disclosed in IEEE EDL Vol. 26, no 3, March 2005, pgs. 212-215

It is one object of the present invention to provide an improved process for fabricating impact-ionization MOSFET devices. It is another object to provide an alternative structure for an impact-ionization MOSFET device (hereinafter "IIMOS device").

According to one aspect as claimed in claim 1, the present invention provides a semiconductor device comprising:
a first source/drain region having a first doping level;
a second source/drain region having a second doping level and of opposite dopant type to the first source/drain region;
the first and second source/drain regions being laterally separated by an intermediate region having a doping level less than either of the first and second doping levels;
a gate electrode electrically insulated from, and disposed over, the intermediate region, the first and second source/drain regions being laterally aligned with the gate electrode;
the entire portion of the first source/drain region that forms a boundary with the intermediate region being separated vertically from the top of the intermediate region.

According to another aspect as claimed in claim 7, the present invention provides a method for fabricating a semiconductor device on a substrate comprising the steps of:
a) forming a first source/drain region having a first doping level;
b) forming a second source/drain region having a second doping level and of opposite dopant type to the first source/drain region, the first and second source/drain regions being laterally separated by an intermediate region having a doping level less than either of the first and second doping levels, wherein the entire portion of the first source/drain region that forms a boundary with the intermediate region is separated vertically from the top of the intermediate region; and
c) forming a gate electrode electrically insulated from, and disposed over, the intermediate region, the first and second source/drain regions being laterally aligned with the gate electrode.

Embodiments of the present invention will now be described by way of example and with reference to the accompanying drawings in which:
Figure 1 shows a schematic cross-sectional view of a conventional IIMOS device;
Figure 2 shows a schematic cross-sectional view of a self-aligned IIMOS device;
Figures 3a to 3f show a series of schematic cross-sectional views depicting a process sequence for fabrication of a device according to figure 2;
Figures 4a to 4e show a series of schematic cross-sectional views depicting an alternative process sequence for fabrication of a device according to figure 2;
Figures 5a to 5d show a series of schematic cross-sectional views depicting an alternative process sequence for fabrication of a device according to figure 2;
Figures 6a to 6h show a series of schematic cross-sectional views depicting an alternative process sequence for fabrication of a pair of devices each according to figure 2;
Figures 7a to 7e show a series of schematic cross-sectional views depicting an alternative process sequence for fabrication of a pair of devices each according to figure 2.

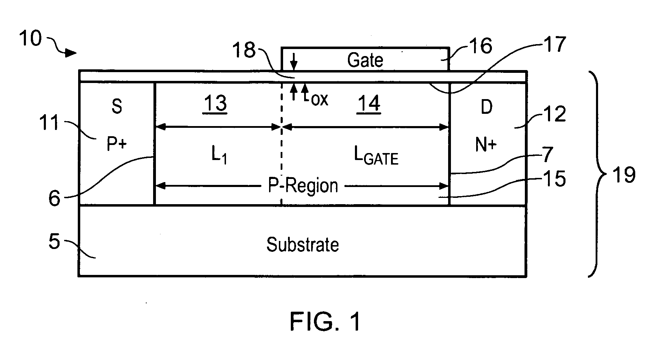

Figure 1 illustrates a conventional IIMOS device 10. A highly doped p+ source region 11 and a highly doped n+ drain region 12 are laterally separated by an intermediate region 15 which comprises a lightly doped p-region. A gate electrode 16 is formed over a first part 14 of the intermediate region 15 which part is hereinafter referred to as the 'gate region' 14. The gate electrode 16 is adjacent to the drain region 12, and is separated from the surface 17 of-the intermediate region 15 by a thin gate dielectric 18. The gate electrode 16 does not extend laterally as far as the p+ source region 11, leaving a second part 13 of the intermediate region 15 which is not covered by the gate electrode 16, hereinafter referred to as the 'extension region' 13. The source and drain regions 11, 12 and intermediate region 15 are conventionally formed in a semiconductor layer 19 on top of a suitable substrate 5.

The gate electrode 16, when electrically biased, is configured to enable the accumulation of carriers (e.g. electrons) under the gate electrode 16 to form an accumulation surface channel. The intermediate region 15 (and particularly the 'extension region' 13) acts as an acceleration path for the carriers in the channel sufficient to generate impact ionization events. The height of the acceleration barrier is controlled by the voltage applied to the gate electrode 16. When the gate voltage is low and insufficient to invert the gate region 14, the maximum energy that the carriers can reach is not sufficient to generate ionization events. When the gate voltage is high and sufficient to form an inversion layer beneath the gate, there is an increased field strength laterally across the intermediate region enabling avalanche multiplication of the carriers and an abrupt increase in the transistor on-current. With such a structure, a sub-threshold slope of 5 mV / decade has been observed.

There are a number of disadvantages with this device structure, however. It is preferable that a field effect transistor is 'self-aligned' in the sense that the material of the gate electrode 16 itself is used to define the critical positions of the source / drain regions. In conventional MOSFET devices, this is achieved by using the gate 16 material as a mask against the doping of the source / drain regions, the edges of which (e.g. junction 7 in figure 1) must be immediately adjacent to the gate electrode. An ion implant of the p+ and n+ doping materials (e.g. boron and arsenic) can be masked by the gate 16 thereby ensuring that the dopant is correctly laterally aligned in the semiconductor layer 19.

In the device of figure 1, this can be achieved with the n+ implant-for the drain region 12, which must be aligned with the edge of the gate electrode 16. However, it can readily be seen that this is not possible for the p+ implant for the source region 11, because the source region 11 is intentionally laterally offset from the left hand edge of the gate electrode 16. Therefore, positioning of the p+ implant relative to the gate electrode typically has to be controlled photolithographically during masking. The lateral offset, indicated by distance L₁ is a critical dimension of the device 10 and reliance on photolithographic alignment control is undesirable.

Another disadvantage is that the additional dimension of the extension region 13 increases the area of the device on the silicon substrate which is counterproductive to efforts to shrink dimensions of the device. A further disadvantage is that, owing to the large energy gap of silicon, a high voltage is required to generate impact ionization events.

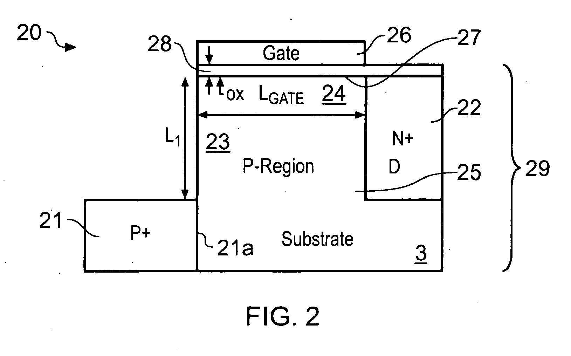

Referring also to figure 2, in the present invention the 'extension region' that provides the offset between the gate electrode and the source or drain region is not provided as a lateral offset L₁ as in figure 1, but as a vertical offset L₁ as shown in figure 2.

Thus, in more detail, the exemplary IIMOS device 20 of figure 2 comprises a drain region 22 and an intermediate region 25 formed in a semiconductor layer 29. In similar manner to figure 1, a gate electrode 26 is formed over the intermediate region 25, adjacent to the drain region 22, and is separated from the surface 27 of the intermediate region 25 by a gate dielectric 28. A source region 21 is provided vertically offset from the gate 26 and from the top surface 27 of the intermediate region 25 by a distance L₁. The gate region 24 (i.e. that portion of the intermediate region 25 where the field effects of the gate electrode dominate) is separated from the interface or boundary 21 a of the source region 21 with the intermediate region 25 by an extension region 23 which extends vertically. The source and drain regions 21, 22 and intermediate region 25 are conventionally formed in a semiconductor layer 29 on top of or, in this example, forming part of a suitable substrate 3.

As will become clear later in discussion of suitable fabrication processes, the source region 21 can now be self-aligned with the gate electrode 26 while still preserving an offset L₁ between the gate region 24 and the source region 21. In this arrangement, the offset is, of course, vertical. The expressions 'horizontal' and 'vertical' as used herein are not intended to limit the disposition of a device 20 but to distinguish between the plane of the gate electrode ('horizontal') and a direction orthogonal thereto ('vertical').

It will also be clear that the offset L₁ between gate region 24 and the source region 21 can now be achieved without significant utilisation of additional device area on the substrate, or with at least substantially reduced area compared with the device of figure 1.

It will be understood that, depending on the device configuration required, the polarity of the source and drain regions 21, 22 can be reversed and the intermediate region may be provided as an intrinsic undoped region or a lightly doped region of either polarity n- or p-. In either case, the intermediate region has a doping level less than that of the source and drain regions. The designations of source and drain may be reversed. Thus, elsewhere in the specification, the relevant regions 21, 22 may be referred to as 'source/drain' regions to maintain generality. The source and drain regions are of opposite dopant type. The source and drain regions may have the same doping levels or may be different.

Suitable processes for fabricating devices exemplified schematically by figure 2 and variations thereof will now be discussed. Throughout the present specification, unless required otherwise by the context, the expression 'substrate' is used to refer not only to the original (e.g. silicon wafer) substrate, but also to include any subsequently deposited and / or defined layers up to the relevant point in the process being described.

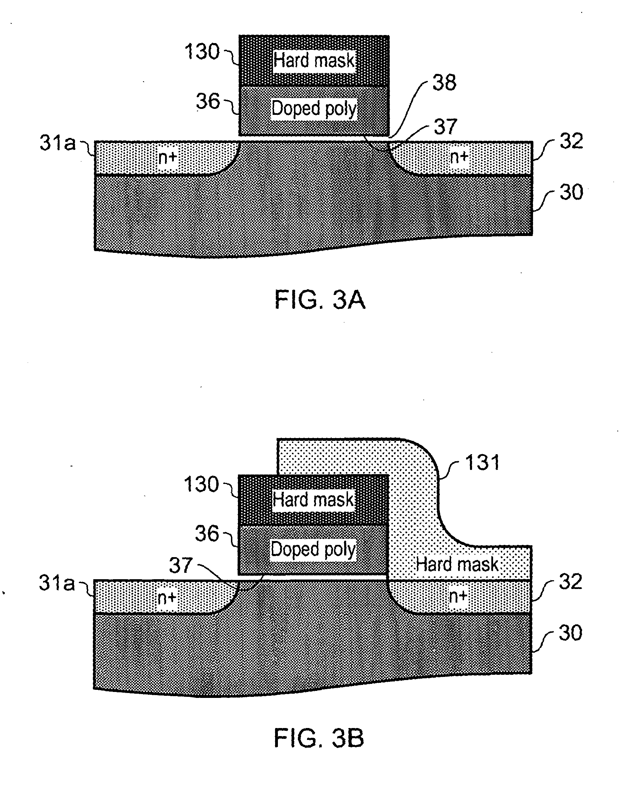

Figure 3a shows a partially completed device fabricated on a substrate according to well known FET fabrication techniques. A gate dielectric 38 has been deposited or grown on the surface 37 of the substrate 30. For example, this dielectric could be formed by oxidation of the surface of the substrate 30. Then, a layer of polysilicon has been deposited and doped to be suitably electrically conductive for use as a gate electrode, covered with a hard mask material 130 such as SiN, SiON, SiO2 or advanced patterning films and subsequently photolithographically defined. The source/drain regions 31a, 32 are then ion implanted with suitable n-type dopant, such as phosphorus or arsenic. The lateral extent of the source/drain regions 31, 32 is defined in part by the presence of the polysilicon gate electrode 36 and hard mask 130 and elsewhere by a suitable photoresist mask (not shown).

As shown in figure 3b, a second hard mask 131 is deposited onto the substrate and photolithographically defined to cover the source/drain region 32 but not to cover the source/drain region 31 a. The second hard mask may be formed using the same or similar materials as for the first hard mask 130.

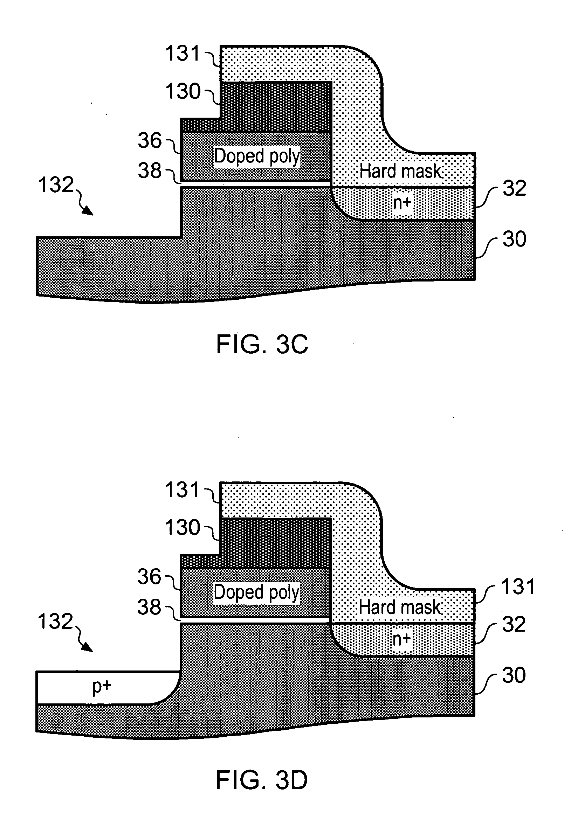

As shown in figure 3c, a recess 132 is etched into the substrate in the source/drain region 31a. The etch depth is preferably approximately equal to the intended length of the extension region 23, i.e. L₁, and more generally may be of similar magnitude to the gate length L_{GATE}. The etch process is effectively self-aligned relative to an edge of the gate electrode 36 by virtue of the first hard mask 130. In this process, it will be noted that the n-type doping introduced to n+ region 31 a is effectively removed. In practice, if convenient, the mask for the original n+ implant (figure 3a) could have covered this region preventing doping of the source/drain region 31 a. During the recess etch, the rest of the substrate is protected by the second hard mask 131 and by small areas of the first hard mask 130 that remain exposed.

As shown in figure 3d, p-type dopant is implanted into the bottom of the recess 132, e.g. by ion implantation, to form a p+ source/drain region 31. The implant is masked elsewhere at least by the first and second hard masks 130, 131. It will be noted that the p+ implant is effectively self-aligned retative to an edge of the gate electrode 36 by virtue of the first hard mask 130 and the gate electrode 36 itself.

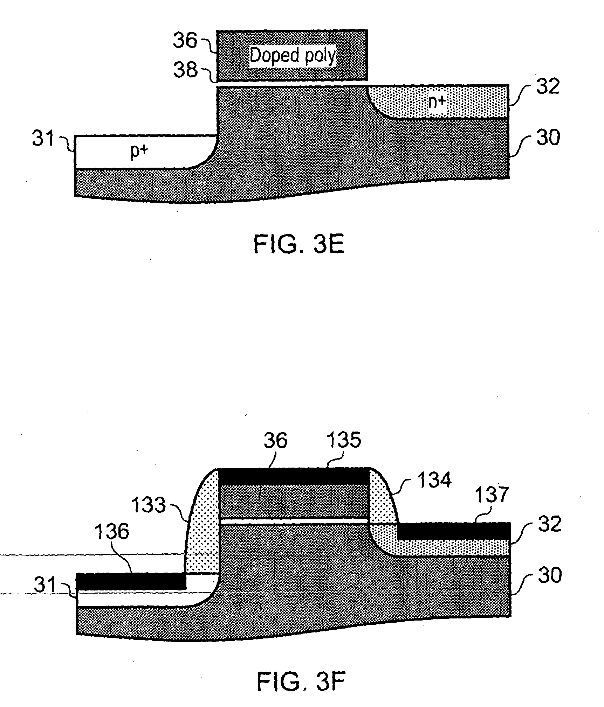

Then, as shown in figure 3e, the first and second hard masks 130, 131 are stripped. There may also be a thermal activation process to activate the n- and p-type dopants of the source/drain regions 31, 32.

As shown in figure 3f, sidewall spacers 133, 134 of suitable dielectric material are deposited using known techniques. Then, silicide caps 135, 136, 137 are formed respectively on the gate electrode 36, the source/drain region 31 and the source/drain region 32. These may be formed using any suitable known process such as deposition of titanium or other metal and thermal processing to react with the underlying silicon, followed by removal of unreacted metal in areas where the substrate was otherwise protected by dielectric spacers 133, 134 or other field oxide layers (not shown).

It will be noted from figure 3f that the source/drain region 31 and its contact silicide layer 136 is below the level of the corresponding contact silicide layer 137 of source/drain region 32. If this proves inconvenient for subsequent processing of interconnect materials to the source/drain regions, such as metal layers, then the source/drain region 31 may be planarized up to the level of the source/drain region 32 using options such as those discussed later.

It will also be noted that other variations in the above process may be made. For example, it may be adapted to use a metal gate electrode material rather than a polysilicon gate. If suitable selectivity of etches against the gate electrode material itself can be achieved, then the first hard mask 130 might be dispensed with. Similarly, the second hard mask 131 might alternatively be replaced with a suitable photoresist mask.

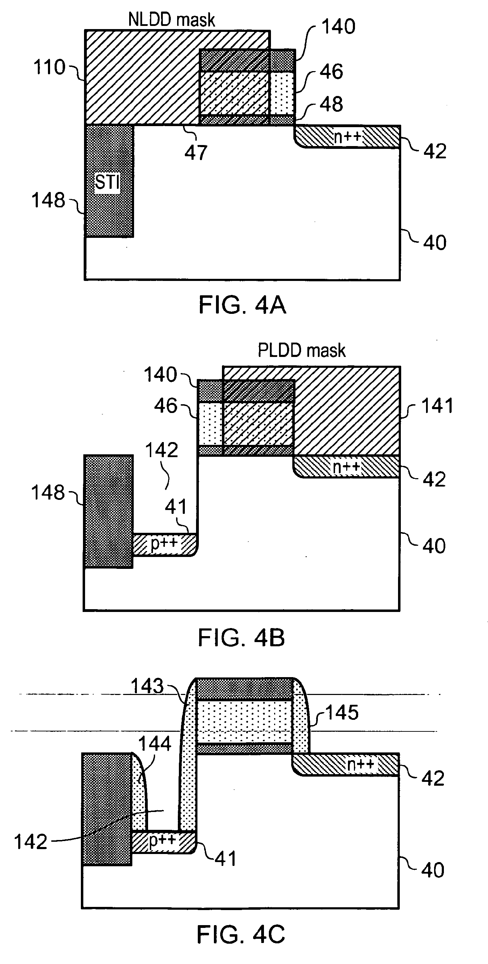

Figures 4a to 4e depict a process in which adjacent devices on the substrate are separated by a trench isolation structure and in which the source/drain regions are formed using two stage processes.

Figure 4a shows a partially completed device fabricated on a substrate 40 according to well known FET fabrication techniques. A gate dielectric 48 has been deposited or grown on the surface 47 of the substrate 40. A gate electrode material and hard mask material have been deposited and subsequently photolithographically defined to form gate 46 and hard mask 140. A trench isolation structure 148 has been formed in the substrate to isolate the device from adjacent devices. The source/drain region 42 has been given a first ion implantation with suitable n-type dopant using a suitable mask 110. The lateral extent of the source/drain region 42 is defined by the presence of the gate electrode 46 and hard mask 140 and elsewhere by the photoresist mask 110.

As shown in figure 4b, a second mask 141 is photolithographically defined on the substrate to cover the source/drain region 42 and a recess or trench 142 is etched into the substrate 40 in the source/drain region 41. The etch depth is preferably approximately equal to the intended length of the extension region 23, i.e. L₁. The etch process is effectively self-aligned relative to an edge of the gate electrode 46 and hard mask 140, and self-aligned to the trench isolation structure 148. A p+ source/drain implant is then used to implant p-type dopant into the substrate at the base of the recess 142, thereby forming the source/drain region 41. The p+ implant process is effectively self-aligned relative to an edge of the gate electrode 46 and hard mask 140, and self-aligned to the trench isolation structure 148, and the implant is masked elsewhere at least by the hard masks 140 and the mask 141.

As shown in figure 4c, the mask 141 is stripped and sidewall spacers 143, 144 and 145 of suitable dielectric material are deposited using known techniques.

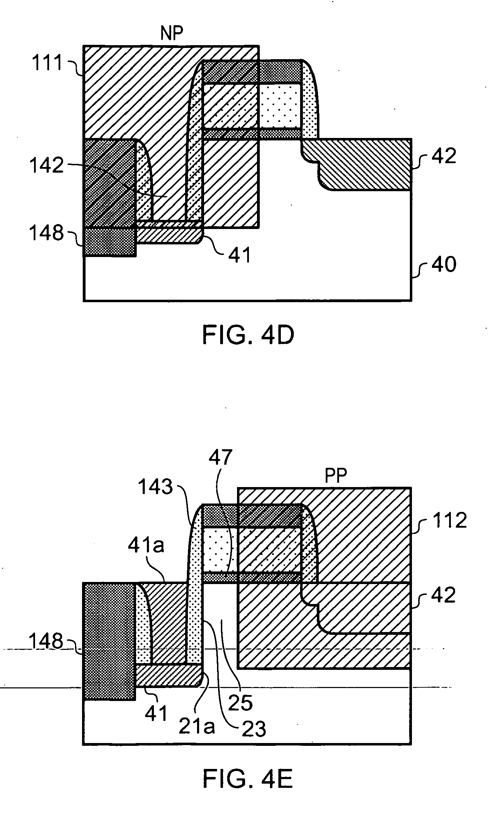

As shown in figure 4d, the trench 142 and source/drain region 41 are covered by a photoresist mask 111 leaving the source/drain region 42 exposed. A further implant process is used at higher energy to implant further n-type dopant into the source/drain region 42.

As shown in figure 4e, the source/drain region 42 is covered by a photoresist mask 112 leaving the trench 142 and source/drain region 41 exposed. An epitaxial deposition process is then used to deposit a further part 41 a of the source/drain region by selective deposition on the exposed silicon of the source/drain region 41. It will be seen, therefore, that the p+ source/drain region in the trench now comprises two portions: a first portion 41 disposed at the bottom of the trench (in this case-implanted into the substrate at the bottom of the trench) and a second portion 41 a within the trench that is separated physically and electrically from the sidewall of the trench and thus separated from the extension region 23 of length L₁ by way of the insulating spacer structure 143.

It can be seen that the portion 41 of the source/drain region that defines the boundary 21 a with the intermediate region 25 is separated vertically from the top 47 of the intermediate region, while the rest of the source/drain region 41 a is separated laterally by an insulating spacer structure 143. It can also be seen that in this particular instance the portion 41 of the source/drain region that defines the boundary 21 a with the intermediate region 25 is separated vertically from the entirety of the source/drain region 42.

In this process, the masks 110, 111, 112 are critically aligned to the gate 46 and therefore can work with gate lengths down to at least 30 nm.

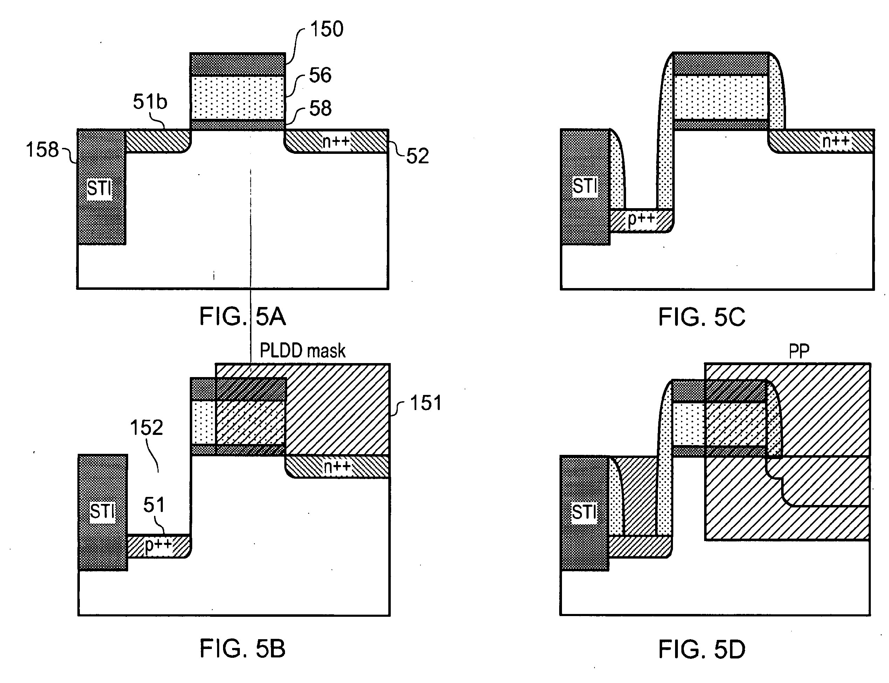

Figures 5a to 5d depict a process in which the n+ implant of the source/drain region 52 is not photolithographically masked, relying on the fact that the resulting implant into the substrate at the other side of the gate (shown as region 51 b) will be removed during recess etch.

Figure 5a shows a trench isolation structure 158, source/drain region 52, gate dielectric 58, gate electrode 56 and hard mask 150 similar to that already explained. The implanted region 51 b will be sacrificed as shown in figure 5b.

Figure 5b shows the structure after the recess has been etched and the p+ source/drain region 51 implanted using mask 151. The remaining process steps are similar to those described in connection with figures 4c and 4e (the additional source/drain implant step of figure 4d being omitted for convenience).

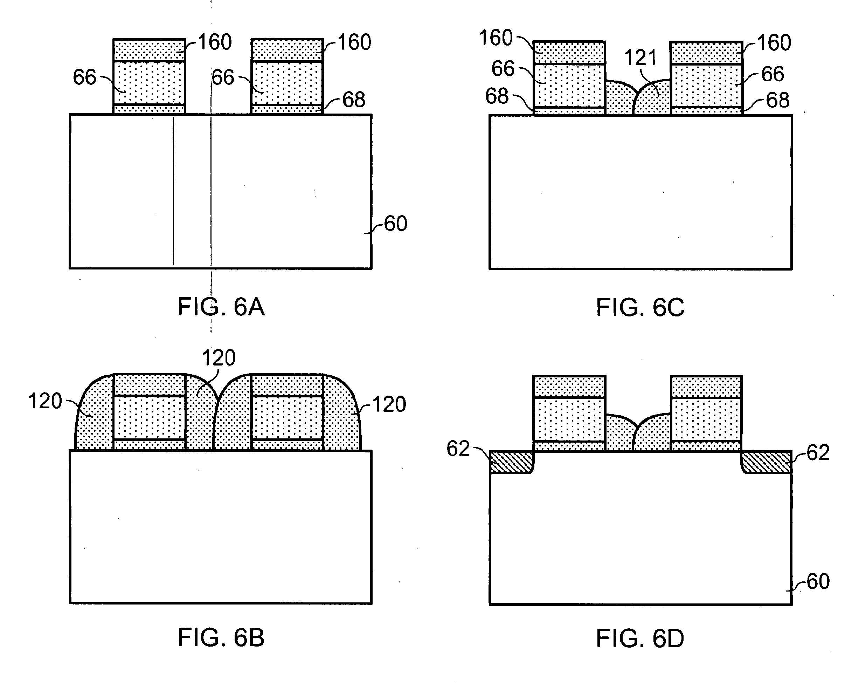

Figures 6a to 6h depict a process in which adjacent devices are formed with a common source/drain region, as commonly required. This shows how the source/drain region 21 adjacent the extension region 23 for two adjacent devices can share the same trench or recess. This process also reduces the number of photolithography masks that need to be aligned to the gate structures.

Figure 6a shows the patterned gate structure for two adjacent devices each with gate dielectric 68, gate electrode 66 and hard mask 160 on substrate 60. Figure 6b shows the structure after sidewall spacers 120 have been formed. Figure 6c shows the structure after an isotropic etch has removed the outer sidewalls leaving residual centre sidewalls 121 between the closely spaced adjacent gate structures 66. These residual sidewalls 121 serve as an implant mask when a shallow n-type implant is carried out to form n+ source/drain regions 62, as shown in figure 6d. Other areas of the substrate 60 may be masked using a conventional photoresist pattern, but this need not be aligned critically to small gate features.

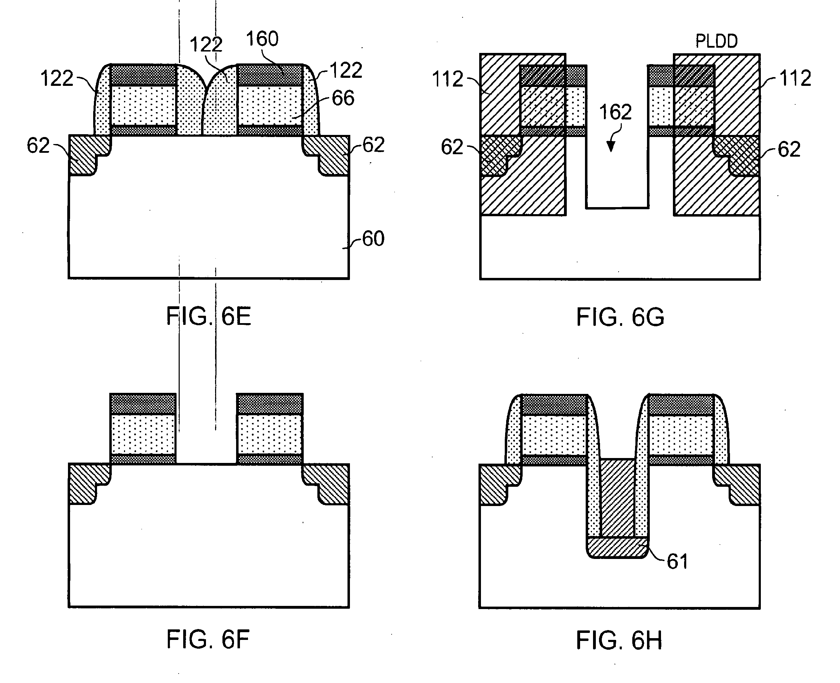

As shown in figure 6e, second spacers 122 are deposited on the gate sidewalls and also to top up the residual spacers 121. These spacers 122 serve as an implant mask when a deeper n-type implant is carried out to further form the n+ source/drain regions 62. Other areas of the substrate 60 may be masked using a conventional photoresist pattern, but this need not be aligned critically to small gate features. The spacers 122 are then removed as shown in figure 6f.

As shown in figure 6g, the n+ source/drain regions 62 are then masked using a photolithographic step with mask 112. In this stage, alignment to the small gate features is required. A trench or recess 162 is then etched, and into this recess is formed the source/drain region 61 using an implant and an epitaxial deposition process as described in connection with figures 4b, 4c and 4e, to give the structure as shown in figure 6h.

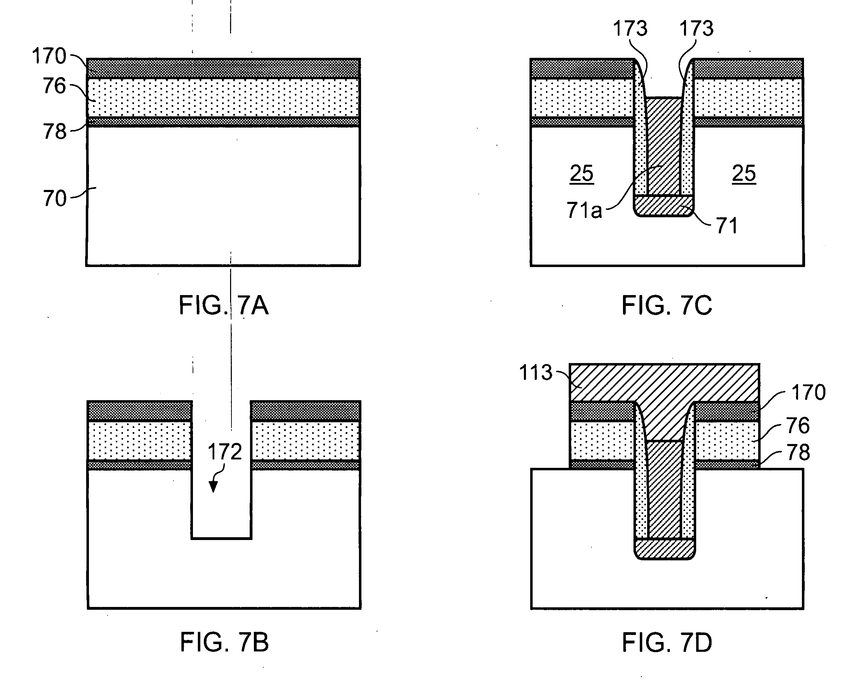

Figures 7a to 7e depict a process in which the recess or trench for the p+ source/drain is formed before the gate structure.

Figure 7a shows the structure after growth of a gate dielectric 78 onto substrate 70, deposition of gate material 76 and deposition of hard mask material 170. As shown in figure 7b, a recess or trench 172 is then etched. As shown in figure 7c, a p+ implant is then performed into the bottom of the recess 172 to form p+ source/drain region 71. Sidewall spacers 173 are then formed on the sides of the recess covering what will become the intermediate portions 25 of the finished devices. An epitaxial deposition process is then used to form a further part 71 a of the p+ source/drain region that is laterally separated from and electrically insulated from the intermediate portions 25 by the sidewall spacers.

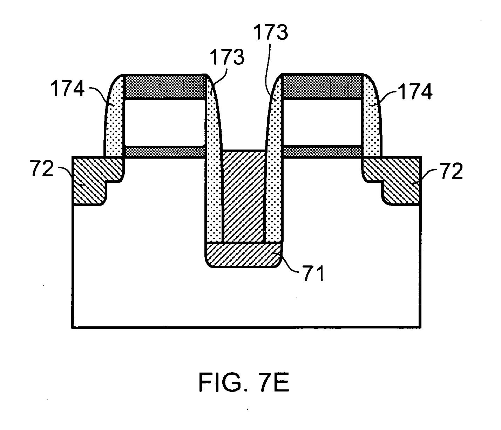

As shown in figure 7d, a mask 113 is then used to pattern the gate electrodes 76. As shown in figure 7e, a first, shallow n+ implant is then performed to form source/drain regions 72, sidewall spacers 174 are then deposited and a second, deeper n+ implant is performed to further form the source/drain regions 72. The mask 113 is then removed.

This process avoids critical alignment control to the gate structure, but alignment variability will affect the relative gate lengths of the left and right hand devices.

Although examples described above have referred to semiconductor devices formed on silicon substrates, it will be understood that the other semiconductor material systems can be used, for example germanium.

## Claims

1. A semiconductor device (20) comprising:
a first source/drain region (21) having a first doping level;
a second source/drain region (22) having a second doping level and of opposite dopant type to the first source/drain region;
the first and second source/drain regions being laterally separated by an intermediate region (25) having a doping level less than either of the first and second doping levels; and
a gate electrode (26) electrically insulated from, and disposed over, the intermediate region, the first and second source/drain regions being laterally aligned with the gate electrode;
the entire portion of the first source/drain region that forms a boundary (21 a) with the intermediate region being separated vertically from the top (27) of the intermediate region, **characterised in that** the portion of the first source/drain region (21) that forms a boundary (21 a) with the intermediate region is separated vertically from the lowest part of the second source/drain region (22).

2. The device of claim 1 in which the source/drain regions (21, 22) and the intermediate region (25) are defined within a semiconductor layer, the first source/drain region (21) having a first portion (41) disposed at the bottom of a trench (142) in the semiconductor layer and a second portion (41 a) within the trench separated from a sidewall of the trench laterally adjacent to the intermediate region by way of an insulating spacer structure (143).

3. The device of claim 2 in which the second portion (41a) of the first source/drain region extends upwards at least as far as the top surface (47) of the intermediate region (25).

4. The device of any preceding claim operable as an impact ionization MOSFET.

5. The device of any preceding claim in which the first source/drain region (21) has a p-type dopant and the second source/drain region (22) has an n-type dopant.

6. The device of any preceding claim in which the first source/drain region (21) is disposed within a trench (162, 172) in a substrate (60) of the device, and further comprising a corresponding device formed on the substrate immediately adjacent to said device, the first source/drain region of each device sharing the trench.

7. A method for fabricating a semiconductor device (20) on a substrate comprising the steps of:
a) forming a first source/drain region (21) having a first doping level;
b) forming a second source/drain region (22) having a second doping level and of opposite dopant type to the first source/drain region, the first and second source/drain regions being laterally separated by an intermediate region (25) having a doping level less than either of the first and second doping levels, wherein the entire portion of the first source/drain region that forms a boundary (21a) with the intermediate region is separated vertically from the top (27) of the intermediate region, and wherein the portion of the first source/drain region (21) that forms a boundary (21 a) with the intermediate region is separated vertically from the lowest part of the second source/drain region (22); and
c) forming a gate electrode (26) electrically insulated from, and disposed over, the intermediate region, the first and second source/drain regions being laterally aligned with the gate electrode.

8. The method of claim 7 in which step b) comprises etching a recess (132) into the substrate in which the first source/drain region (31) can be formed.

9. The method of claim 8 further including aligning the recess etch relative to an edge of the gate electrode formed in step c).

10. The method of claim 8 in which step b) further includes introducing dopant into the bottom of the recess.

11. The method of claim 10 in which the step of introducing dopant into the bottom of the recess includes implanting dopant into the substrate at the bottom of the recess.

12. The method of claim 10 or claim 11 in which the step of introducing dopant into the bottom of the recess includes depositing doped material (41 a) into the recess.

13. The method of claim 9 in which step b) comprises the steps of
i) implanting dopant into the bottom of the recess;
ii) depositing a spacer (143) of dielectric material onto a sidewall of the recess which sidewall defines an edge of the intermediate region.

14. The method of claim 13 further including, after step ii),
iii) at least partially refilling the recess (142) with doped material to form a further part (41 a) of the first source/drain region (21), the further part of the first source/drain region being separated from the intermediate region (25) by the spacer (143).

## Patentansprüche

1. Halbleitervorrichtung (20), umfassend:
ein erstes Source/Drain-Gebiet (21), das ein erstes Dotierungsniveau aufweist;
ein zweites Source/Drain-Gebiet (22), das ein zweites Dotierungsniveau aufweist und einen zum ersten Source/Drain-Gebiet entgegengesetzten Dotierungstyp aufweist;
wobei das erste und das zweite Source/Drain-Gebiet lateral durch ein Zwischengebiet (25) getrennt sind, das ein niedrigeres Dotierungsniveau als jedes der ersten und zweiten Dotierungsniveaus aufweist; und
eine Gate-Elektrode (26), die vom Zwischengebiet elektrisch isoliert ist und über demselben angeordnet ist, wobei das erste und das zweite Source/Drain-Gebiet lateral auf die Gate-Elektrode ausgerichtet sind;
wobei der gesamte Teil des ersten Source/Drain-Gebiets, der eine Grenze (21 a) mit dem Zwischengebiet bildet, von der Oberseite (27) des Zwischengebiets vertikal getrennt ist;
**dadurch gekennzeichnet, dass**
der Teil des ersten Source/Drain-Gebiets (21), der eine Grenze (21 a) mit dem Zwischengebiet bildet, vom untersten Teil des zweiten Source/Drain-Gebiets (22) vertikal getrennt ist.

2. Vorrichtung nach Anspruch 1, in der die Source/Drain-Gebiete (21, 22) und das Zwischengebiet (25) innerhalb einer Halbleiterschicht definiert sind, wobei das erste Source/Drain-Gebiet (21) einen ersten Teil (41), der am Boden eines Grabens (142) in der Halbleiterschicht angeordnet ist, und einen zweiten Teil (41 a) innerhalb des Grabens durch eine isolierende Abstandhalterstruktur (143) getrennt von einer Seitenwand des Grabens lateral benachbart zu dem Zwischengebiet aufweist.

3. Vorrichtung nach Anspruch 2, in der der zweite Teil (41a) des ersten Source/Drain-Gebiets sich wenigstens bis zu der oberen Oberfläche (47) des Zwischengebiets (25) nach oben erstreckt.

4. Vorrichtung nach irgendeinem der vorangehenden Ansprüche, die als ein Stoßionisierungs-MOSFET betreibbar ist.

5. Vorrichtung nach irgendeinem der vorangehenden Ansprüche, in der das erste Source/Drain-Gebiet (21) einen p-Typ-Dotierungsstoff aufweist und das zweite Source/Drain-Gebiet (22) einen n-Typ-Dotierungsstoff aufweist.

6. Vorrichtung nach irgendeinem der vorangehenden Ansprüche, in der das erste Source/Drain-Gebiet (21) innerhalb eines Grabens (162, 172) in einem Substrat (60) der Vorrichtung angeordnet ist und ferner eine entsprechende Vorrichtung umfasst, die auf dem Substrat unmittelbar benachbart zu der Vorrichtung ausgebildet ist, wobei das erste Source/Drain-Gebiet einer jeden Vorrichtung an dem Graben teilhat.

7. Verfahren zur Herstellung einer Halbleitervorrichtung (20) auf einem Substrat, die Schritte umfassend:
a) Bilden eines ersten Source/Drain-Gebiets (21), das ein erstes Dotierungsniveau aufweist;
b) Bilden eines zweiten Source/Drain-Gebiets (22), das ein zweites Dotierungsniveau aufweist und einen zum ersten Source/Drain-Gebiet entgegengesetzten Dotierungsstofftyp aufweist, wobei das erste und das zweite Source/Drain-Gebiet lateral durch ein Zwischengebiet (25) getrennt sind, das ein niedrigeres Dotierungsniveau als jedes der ersten und zweiten Dotierungsniveaus aufweist, wobei der gesamte Teil des ersten Source/Drain-Gebiets, der eine Grenze (21 a) mit dem Zwischengebiet bildet, von der Oberseite (27) des Zwischengebiets vertikal getrennt ist, und wobei der Teil des ersten Source/Drain-Gebiets (21), der eine Grenze (21 a) mit dem Zwischengebiet bildet, von dem untersten Teil des zweiten Source/Drain-Gebiets (22) vertikal getrennt ist; und
c) Bilden einer Gate-Elektrode (26), die von dem Zwischengebiet elektrisch isoliert ist und über demselben angeordnet ist, wobei das erste und das zweite Source-Drain-Gebiet lateral auf die Gate-Elektrode ausgerichtet sind.

8. Verfahren nach Anspruch 7, in dem Schritt b) das Ätzen einer Aussparung (132) in das Substrat umfasst, in der das erste Source/Drain-Gebiet (31) ausgebildet werden kann.

9. Verfahren nach Anspruch 8, das ferner das Ausrichten der Aussparungsätzung relativ zu einem Rand der im Schritt c) gebildeten Gate-Elektrode enthält.

10. Verfahren nach Anspruch 8, in dem Schritt b) ferner das Einbringen eines Dotierungsstoffes in den Boden der Aussparung enthält.

11. Verfahren nach Anspruch 10, in dem der Schritt des Einbringens eines Dotierungsstoffes in den Boden der Aussparung das Implantieren eines Dotierungsstoffes in das Substrat am Boden der Aussparung enthält.

12. Verfahren nach Anspruch 10 oder Anspruch 11, in dem der Schritt des Einbringens eines Dotierungsstoffes in den Boden der Aussparung das Abscheiden von dotiertem Material (41 a) in der Aussparung enthält.

13. Verfahren nach Anspruch 9, in dem Schritt b) die Schritte umfasst:
i) Implantieren eines Dotierungsstoffes in den Boden der Aussparung;
ii) Abscheiden eines Abstandhalters (143) aus dielektrischem Material auf einer Seitenwand der Aussparung, wobei die Seitenwand einen Rand des Zwischengebiets definiert.

14. Verfahren nach Anspruch 13, nach Schritt ii) ferner enthaltend:
iii) wenigstens teilweises Wiederauffüllen der Aussparung (142) mit dotiertem Material, um einen weiteren Teil (41 a) des ersten Source/Drain-Gebiets (21) zu bilden, wobei der weitere Teil des ersten Source/Drain-Gebiets von dem Zwischengebiet (25) durch den Abstandhalter (143) getrennt ist.

## Revendications

1. Dispositif à semi-conducteurs (20) comprenant :
une première région source / drain (21) ayant un premier niveau de dopage ;
une deuxième région source / drain (22) ayant un deuxième niveau de dopage et un type de dopant opposé à celui de la première région source / drain ;
la première et la deuxième région source / drain étant séparées latéralement par une région intermédiaire (25) ayant un niveau de dopage inférieur au premier et au deuxième niveau de dopage ; et
une électrode de grille (26) isolée électriquement de la région intermédiaire et disposée sur celle-ci, la première et la deuxième région source / drain étant alignées latéralement avec l'électrode de grille ;
la totalité de la partie de la première région source / drain qui forme une frontière (21a) avec la partie intermédiaire étant séparée verticalement de la partie supérieure (27) de la région intermédiaire, **caractérisé**
**par le fait que** la partie de la première région source / drain (21) qui forme un frontière (21a) avec la région intermédiaire est séparée verticalement de la partie inférieure de la deuxième région source / drain (22).

2. Dispositif selon la revendication 1, dans lequel les régions source / drain (21, 22) et la région intermédiaire (25) sont définies dans une couche de semi-conducteur, la première région source / drain (21) ayant une première partie (41) disposée au fond d'une tranchée (142) dans la couche de semi-conducteur et une deuxième partie (41a) dans la tranchée séparée d'une paroi latérale de la tranchée adjacente latéralement à la région intermédiaire par l'intermédiaire d'une structure d'espaceur isolant (143).

3. Dispositif selon la revendication 2 dans lequel la deuxième partie (41a) de la première région source / drain s'étend vers le haut au moins aussi loin que la surface supérieure (47 de la région intermédiaire (25).

4. Dispositif selon l'une quelconque des revendications précédentes pouvant fonctionner en tant que MOSFET à ionisation d'impact.

5. Dispositif selon l'une quelconque des revendications précédentes, dans lequel la première région source / drain (21) a un dopant de type p et la deuxième région source / drain (22) a un dopant de type n.

6. Dispositif selon l'une quelconque des revendications précédentes, dans lequel la première région source / drain (21) est disposée dans une tranchée (162, 172) dans un substrat (60) du dispositif, et comportant en outre un dispositif correspondant formé sur le substrat immédiatement adjacent audit dispositif, la première région source / drain de chaque dispositif partageant la tranchée.

7. Procédé de fabrication d'un dispositif à semi-conducteurs (20) sur un substrat, comprenant les étapes suivantes :
a) formation d'une première région source / drain (21) ayant un premier niveau de dopage ;
b) formation d'une deuxième région source / drain (22) ayant un deuxième niveau de dopage et un type de dopant opposé à celui de la première région source / drain, la première et la deuxième région source / drain étant séparées latéralement par une région intermédiaire (25) ayant un niveau de dopage inférieur au premier et au deuxième niveaux de dopage, dans lequel la totalité de la partie de la première région source / drain qui forme une frontière (21a) avec la région intermédiaire est séparée verticalement de la partie supérieure (27) de la région intermédiaire, et dans lequel la partie de la première région source / drain (21) qui forme une frontière (21a) avec la partie intermédiaire est séparée verticalement de la partie inférieure de la deuxième région source / drain (22) ; et
c) formation d'une électrode de grille (26) isolée électriquement de la région intermédiaire et disposée sur celle-ci, la première et la deuxième région source / drain étant alignées latéralement avec l'électrode de grille.

8. Procédé selon la revendication 7, dans lequel l'étape b) comporte la gravure d'un renfoncement (132) dans le substrat dans lequel peut être formée la première région source / drain (31).

9. Procédé selon la revendication 8, comprenant en outre l'alignement de la gravure du renfoncement par rapport à un bord de l'électrode de grille formée à l'étape c).

10. Procédé selon la revendication 8, dans lequel l'étape b) comporte en outre l'introduction de dopant dans le fond du renfoncement.

11. Procédé selon la revendication 10, dans lequel l'étape d'introduction de dopant dans le fond du renfoncement inclut l'implantation de dopant dans le substrat au fond du renfoncement.

12. Procédé selon la revendication 10 ou la revendication 11, dans lequel l'étape d'introduction de dopant dans le fond du renfoncement inclut le dépôt de matériau dopant (41a) dans le renfoncement.

13. Procédé selon la revendication 9 dans lequel l'étape b) comporte les étapes consistant à :
i) implanter du dopant dans le fond du renfoncement ;
ii) déposer un espaceur (143) de matériau diélectrique sur une paroi latérale du renfoncement, laquelle paroi latérale définit un bord de la région intermédiaire.

14. Procédé selon la revendication 13, comprenant en outre, après l'étape ii),
iii) le re-remplissage au moins partiel du renfoncement (142) avec du matériau dopé pour former une autre partie (41a) de la première région source / drain (21), l'autre partie de la première région source / drain étant séparée de la région intermédiaire (25) par l'espaceur (143).
